Europäisches Patentamt

European Patent Office

Office européen des brevets

(11) Publication number: **0 246 802**
**A2**

# (12) EUROPEAN PATENT APPLICATION

(21) Application number: **87304228.7**

(22) Date of filing: **13.05.87**

(51) Int. Cl.⁴: **H01L 21/306**

(30) Priority: **20.05.86 JP 116423/86**

(43) Date of publication of application:
**25.11.87 Bulletin 87/48**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Sugino, Rinshi**
**1167-1, Sanda**
**Atsugi-shi Kanagawa 243-02(JP)**
Inventor: **Ito, Takashi**
**408, Noborito Tama-ku**
**Kawasaki-shi Kanagawa 214(JP)**

(74) Representative: **Billington, Lawrence Emlyn et al**
**HASELTINE LAKE & CO Hazlitt House 28**
**Southampton Buildings Chancery Lane**
**London WC2A 1AT(GB)**

(54) **Process for cleaning surface of semiconductor substrate.**

(57) The surface of a semiconductor substrate can be cleaned effectively by first etching the surface with an atmosphere containing a free halogen or a halogen compound, irradiated with UV-rays, followed by wet solution cleaning.

## Fig. I

```
┌─────────────────────────────┐
│ SUBSTRATE PLACED IN CHLORINE│
│ GAS ATMOSPHERE AND IRRADIATED│
│ WITH UV-RAYS TO ETCH SURFACE│
│ OF SUBSTRATE                │
└─────────────────────────────┘
                │
┌─────────────────────────────────────────────────┐
│ RINSING SUBSTRATE                               │
│ (FIRST WITH RUNNING DEIONIZED WATER FOLLOWED    │
│  BY IMMERSION IN BOILING DEIONIZED WATER )      │
└─────────────────────────────────────────────────┘
                │
┌─────────────────────────────────────────────────┐
│ FIRST WET CLEANING WITH FLUORIC ACID SOLUTION   │
└─────────────────────────────────────────────────┘
                │
        ┌───────────────────┐
        │ RINSING SUBSTRATE │
        └───────────────────┘
                │
┌─────────────────────────────────────────────────┐
│ SECOND WET CLEANING WITH SOLUTION               │
│ CONTAINING HYDROGEN PEROXIDE AND AMMONIA        │
└─────────────────────────────────────────────────┘
                │
        ┌───────────────────┐
        │ RINSING SUBSTRATE │
        └───────────────────┘
                │
         * END OF CLEANING PROCESS
                │
┌─────────────────────────────────────┐
│ OXIDIZING TO FORM OXIDE LAYER       │
└─────────────────────────────────────┘
```

Xerox Copy Centre

## PROCESS FOR CLEANING SURFACE OF SEMICONDUCTOR SUBSTRATE

The present invention relates to a process for treating a surface of a semiconductor substrate, more specifically, to a process for cleaning a surface of a semiconductor substrate for example prior to forming an epitaxial layer, a CVD layer a thermal oxide layer, a thermal nitride layer, or other film layer on the substrate.

In a known process for cleaning a surface of a semiconductor substrate, the surface is wet cleaned with an aqueous solution containing hydrogen peroxide and ammonia (for example, RCA Review, June 1970, pp 187-206). The cleaning efficiency of this process is, however, unsatisfactory.

A more effective process for cleaning a surface of a semiconductor substrate is known, in which the surface of the semiconductor substrate is preoxidized (also referred to as sacrifical oxidation) before wet cleaning as mentioned-above. This process comprises, for example, sequentially wet cleaning a substrate, oxidizing a surface of the substrate, removing the oxidized layer from the substrate, wet cleaning the surface of the substrate again, and forming a required layer on the surface of the substrate. However, this process is disadvantageous in that it involves many complicated steps, including the oxidation step. Moreover, the heat treatment necessary for oxidation causes contaminants to diffuse into the semiconductor substrate, so that removal of the contaminants is made more difficult. Particularly, when an extremely thin layer such as a gate insulating layer of a MOS-VLSI is formed on the cleaned surface of the substrate, such remaining contaminants cause a deterioration of the extremely thin layer.

An embodiment of the present invention may provide a process for treating a surface of a semiconductor substrate, which process permits an unimpaired layer to be formed on the treated surface of the substrate.

According to the present invention, there is provided a process for treating a surface of a semiconductor substrate, said process comprising the steps of:

etching a surface of the semiconductor in a atmosphere containing a free halogen or a halogen compound and irradiating at least one of the atmosphere above the semiconductor substrate and the surface of the semiconductor substrate with ultraviolet rays; and then

wet cleaning the surface of the semiconductor substrate with a cleaning solution.

According to a development of the present invention, there is provided a process for treating a surface of a silicon semiconductor substrate, said process comprising the steps of:

etching a surface of the silicon semiconductor substrate by placing the substrate in an atmosphere containing a free halogen or halogen compound and irradiating at least one of the atmosphere above the substrate and the surface of the semiconductor substrate with ultraviolet rays;

rinsing the substrate;

wet cleaning the surface of the substrate with an aqueous fluoric acid solution;

rinsing the substrate;

wet cleaning the surface of the substrate with an aqueous solution containing hydrogen peroxide and ammonia; and

rinsing the substrate.

When ultraviolet rays are irradiated in a halogen-containing atmosphere, the halogen is excited and is brought to a radical or ion state, and etches the surface of a semiconductor substrate. In this case, since heat is not applied, contaminants existing on the adjacent to the surfaceare not caused to diffuse into the semiconductor substrate and, therefore, are easily and completely removed by etching. At the same time, contaminants such as alkali or other metals in the semiconductor substrate are effectively extracted due to formation of chemical bonds with the halogen radicals.

Although reaction products formed from halogen and substrate-constituting materials, for example, silicon, remain on the surface of the semiconductor substrate after halogen etching, these reaction products are easily removed by subsequently wet cleaning the substrate, for example with an aqueous solution containing hydrogen peroxide and ammonia. Reference is made, by way of example, to the accompanying drawings in which:

Figure 1 is a flow chart of a preferred process employing to the present invention; and

Fig. 2 is a schematic view of an etching system which can be used in a process employing the present invention.

A trial example of a process according to the present inventionwillnowbe described with reference to the drawings.

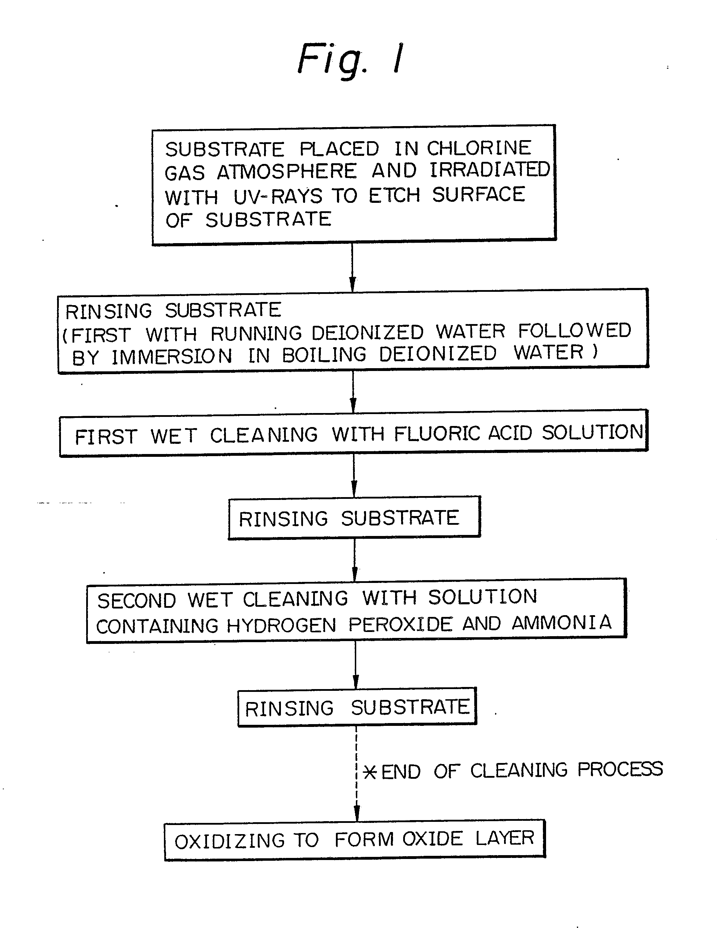

Figure 1 is a flow chart of a preferred process for treating a surface of a semiconductor substrate, as described below.

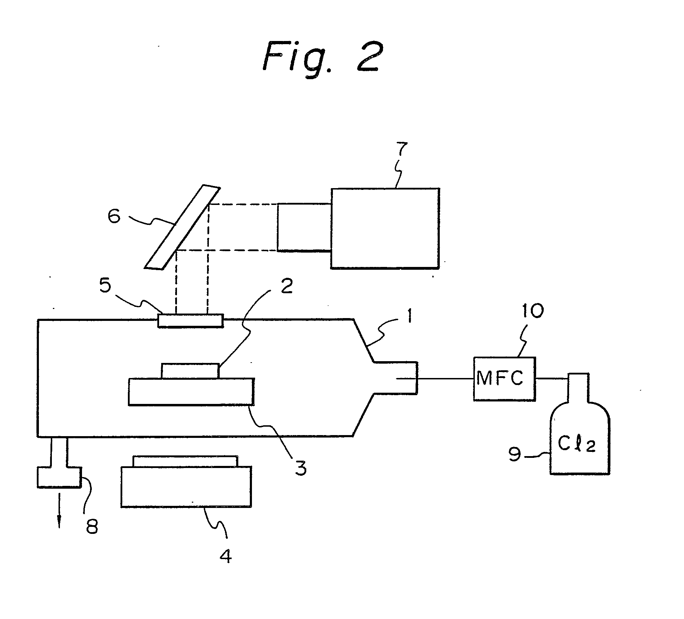

Figure 2 is a diagram of an etching system, in which reference numeral 1 denotes an etching chamber, 2 a semiconductor substrate, 3 a susceptor for supporting the substrate 1, 4 an IR heater, 5 a quartz window for transmitting UV rays, 6 a mirror, 7 a UV rays source, 8 a connector to a vacuum pump, 9 a container of chlorine, and 10 a valve.

A p-type silicon substrate 2, for example, was placed on the susceptor 3 in chamber 1 and heated to about 100°C. High purity chlorine ($Cl_2$) gas, as an etching gas, was introduced from the chlorine container 9 into the chamber 1 and the chamber 1 evacuated to about 20 Torr.

From the UV source 7, UV rays having a wavelength of 150 to 350 nm were irradiated toward the substrate 2 through the window 5 at a strength of 10 to 200 mW/cm$^2$ for 1 to 5 minutes.

This irradiation caused the chlorine gas to become excited and be brought to a radical state, and thus etch the surface of the silicon substrate 2 to a depth of 10 to 100 nm.

The substrate 2 was then rinsed with running deionized water followed by immersion in boiling deionized water. Subsequently, the substrate was subjected to conventional wet solution cleaning, wherein first the substrate was wet cleaned with a 3% aqueous fluoric acid solution, rinsed with running deionized water and boiling deionized water, and then wet cleaned with an aqueous solution containing 22% hydrogen peroxide and 16% ammonia.

Finally, the substrate was rinsed with running deionized water and then immersed in boiling deionized water.

This completed the surface treatment or cleaning of a silicon substrate in this example of the present invention.

After a surface of a silicon substrate was cleaned as described above, the cleaned surface of the silicon substrate was oxidized at 1000°C for 10 minutes to form a silicon dioxide layer having a thickness of 20 nm. The breakdown voltage of the silicon dioxide layer was 10.5 MV/cm.

For comparison, the same silicon substrate as above was subjected to the same wet solution cleaning as above, without a prior irradiation of UV rays in a halogen-containing atmosphere, and oxidized to form a silicon dioxide layer having a thickness of 20 nm. The breakdown voltage of this silicon dioxide layer was 9.5 MV/cm.

Atomic absorption spectroscopy was conducted to examine the surface contamination of the resultant two silicon substrates. The results are shown in the following Table.

## Table

|  | (unit: ppb) | | | |
|---|---|---|---|---|
|  | Al | Fe | Na | Cr |
| Solution wash only | 300 | 31 | 6 | 0.6 |
| UV-Cl treatment +wet Solution cleaning | 150 | 11 | 3 | 0.06 |

From the above, it is apparent that the surface of the silicon substrate is more effectively cleaned by a process according to the present invention than by a conventional process.

Similar effects can be obtained by replacing the chlorine gas with another halogen such as $F_2$ or $Br_2$, a hydrogen halide such as HCl, HF or HBr, a boron halide such as $BCl_3$, $BF_3$ or $BBr_3$, an interhalogen compound such as ClF and BrF, a nitrogen halide such as $NF_3$ or $N_2F_2$, a rare gas halide such as $XeF_2$, $KrF_2$ or $XeCl_2$ or the like. The semiconductor substrate may be a compound semiconductor substrate. Other wet cleaning solutions, for example, a solution containing hydrogen chloride and hydrogen peroxide ($HCl \bullet H_2O_2 \bullet H_2O$) or nitric acid ($HNO_3$) solution may be used.

## Claims

1. A process for treating a surface of a semiconductor substrate, said process comprising the steps of:
etching a surface of the semiconductor substrate by placing the semiconductor substrate in an atmosphere containing a free halogen or a halogen compound and irradiating at least one of the atmosphere above the semiconductor substrate and the surface of the semiconductor substrate with ultraviolet rays; and then
wet cleaning the surface of the semiconductor substrate with a cleaning solution.

2. A process according to claim 1, wherein said atmosphere contains at least one of the group consisting of $Cl_2$, $F_2$, $Br_2$, HCl, HF, HBr, $BCl_3$, $BF_3$, $BBr_3$, ClF, BrF, $NF_3$, $N_2F_2$, $XeF_2$, $KrF_2$, $CCl_4$ and $XeCl_2$.

3. A process according to claim 1, or 2, wherein said wet cleaning step comprises wet cleaning the surface of the semiconductor substrate first with a fluoric acid solution and then with a solution containing hydrogen peroxide and ammonia.

4. A process according to claim 1, 2 or 3, wherein said semiconductor substrate is made of silicon.

5. A process for treating a surface of a silicon semiconductor substrate, said process comprising the steps of:
etching a surface of the silicon semiconductor substrate by placing the substrate in an atmosphere containing a free halogen or a halogen compound and irradiating at least one of the atmosphere above the substrate and the surface of the semiconductor substrate with ultraviolet rays;
rinsing the substrate;
wet cleaning the surface of the substrate with an aqueous fluoric acid solution;
rinsing the the substrate;
wet cleaning the surface of the substrate with an aqueous solution containing hydrogen peroxide and ammonia; and
rinsing the substrate.

6. A process according to claim 5, wherein said rinsing steps are all conducted by first cleaning the surface of the substrate with running deionized water and then immersing the substrate in boiling deionized water.

# Fig. 1

```
┌──────────────────────────────────┐
│ SUBSTRATE PLACED IN CHLORINE     │
│ GAS ATMOSPHERE AND IRRADIATED    │
│ WITH UV-RAYS TO ETCH SURFACE     │
│ OF SUBSTRATE                     │
└──────────────────────────────────┘
                 │
                 ▼
┌──────────────────────────────────────────────────┐
│ RINSING SUBSTRATE                                  │
│ (FIRST WITH RUNNING DEIONIZED WATER FOLLOWED       │
│  BY IMMERSION IN BOILING DEIONIZED WATER )         │
└──────────────────────────────────────────────────┘
                 │
                 ▼
┌──────────────────────────────────────────────────┐
│ FIRST WET CLEANING WITH FLUORIC ACID SOLUTION      │
└──────────────────────────────────────────────────┘
                 │
                 ▼
      ┌──────────────────────┐
      │ RINSING SUBSTRATE    │
      └──────────────────────┘
                 │
                 ▼
┌──────────────────────────────────────────────────┐
│ SECOND WET CLEANING WITH SOLUTION                  │
│ CONTAINING HYDROGEN PEROXIDE AND AMMONIA           │
└──────────────────────────────────────────────────┘
                 │
                 ▼
      ┌──────────────────────┐
      │ RINSING SUBSTRATE    │
      └──────────────────────┘
                 ┊
                 ┊ *END OF CLEANING PROCESS
                 ▼
┌──────────────────────────────────────────────────┐
│ OXIDIZING TO FORM OXIDE LAYER                      │
└──────────────────────────────────────────────────┘
```

# Fig. 2